# EUROPÄISCHE PATENTANMELDUNG

(11) **EP 1 837 065 A2**
(43) Veröffentlichungstag der Anmeldung: **26.09.2007**
(21) Anmeldenummer: 07005933.2
(22) Anmeldetag: 22.03.2007
(51) Int. Cl.: B01D 46/42

(54) **Filtersystem**

(30) Priorität: 22.03.2006 DE 102006013204
(71) Anmelder: Adva AG Optical Networking, 82152 Martinsried (DE)
(72) Erfinder: Feldmann, Roland, 98617 Meiningen (DE)
(74) Vertreter: Mischung, Ralf

(57) **Zusammenfassung**

Die Erfindung betrifft ein Filtersystem, insbesondere zur Luftreinigung eines zu belüftenden Schaltschranks, wobei ein Filtergehäuse in einer ersten Richtung durch einen Einführschacht einschiebbar ist und im Laufe der Einschubbewegung einen Bewegungsanteil senkrecht zur ersten Einschubrichtung erfährt, um dabei die gewünschte Endlage des Filtergehäuses zu erreichen.

## Beschreibung

Die vorliegende Erfindung betrifft ein Filtersystem, insbesondere zur Luftreinigung eines zu belüftenden Schaltschranks oder Baugruppenträgers sowie einen Schaltschrank.

Aus dem Stand der Technik sind Schaltschränke oder Baugruppenträger-Gehäuse bekannt, deren innen liegende Komponenten durch Luftströme gekühlt werden müssen. Um gleichzeitig eine Verschmutzung der Innenräume zu vermeiden, wird die Luft üblicherweise vor dem Eintritt in das Gehäuse durch ein Filterelement gereinigt.

Als problematisch hat sich in der Praxis das Einsetzen bzw. Herausnehmen der Filterelemente herausgestellt. So müssen die Filterelemente einerseits austauschbar sein, andererseits müssen sie an einer schwer zugänglichen Stelle eine Lüftungsöffnung des Schaltschranks abdecken. Auch muss beim Wechseln des Filterelements berücksichtigt werden, dass Kabel, Lichtwellenleiter oder sonstige Komponenten im Schaltschrank oder in seiner unmittelbaren Nähe nicht störend im Weg stehen bzw. nicht beschädigt werden dürfen. Weiterhin führen oftmals Kabelkanäle unterhalb oder quer zu den eigentlichen Schaltschränken, so dass das Einsetzen von Filterelementen, insbesondere im zu bevorzugenden Bodenbereich der Gehäuse unhandlich und mit einem Beschädigungsrisiko für die Schaltschrankkomponenten verbunden ist.

Aus der DE 198 17 387 B2 ist ein Klimagerät für einen Schaltschrank bekannt, bei dem das Filterelement unter einem Winkel zur Vertikalen in einem Luftführungskanal angeordnet ist, wobei es durch ein Federelement in seiner Lage fixiert wird. Der Nachteil liegt hier in der raumgreifenden Anordnung des Filterelements. Auch der Wechsel des Filterelements ist nach wie vor schwierig und nur bei unmittelbarem Zugriff auf den Lüftungskanal möglich. Aus der DE 7500977 ist ein Luftfiltergehäuse mit Spannvorrichtung bekannt, welches zur Aufnahme von Filterzellen zur Reinigung von Luft oder Gasen vorgesehen ist. Mit Hilfe einer Spindel sind dabei Filterelemente gegen Anlageflächen anpressbar. Die Anordnung und der Wechsel der Filterelemente ist jedoch recht aufwändig.

Aus der CH 448 693 ist eine Anpressvorrichtung zum dichten Einsetzen auswechselbarer Filter in Abluftkanäle bekannt. Die Filterelemente werden dabei mittels eines Kniegelenkhebel-Mechanismus in Anpresslage gebracht bzw. davon gelöst. Auch diese Ausführung ist konstruktiv aufwändig und beansprucht (insbesondere für die Betätigung) viel Bauraum.

Aufgabe der Erfindung ist es daher, ein Filtersystem, insbesondere für Schaltschränke oder Baugruppenträger, zu schaffen, bei dem das oder die Filterelemente leicht austauschbar sind, ohne dabei externe oder interne Komponenten des Schaltschranks oder Baugruppenträgers zu beeinflussen, zu beschädigen oder den Schaltschrank in seinem Aufbau nennenswert zu beeinflussen. Die Aufgabe wird gelöst durch ein Filtersystem nach Anspruch 1 und durch einen Schaltschrank nach Anspruch 9.
Die Erfindung geht dabei von der Erkenntnis aus, dass das Filterelement durch einen Einfuhrschacht ein- und ausgewechselt werden kann. Der Einfuhrschacht kann vorteilhafterweise unterhalb oder seitlich des Schaltschranks oder Baugruppenträgers liegen, so dass z.B. Kabelkanäle beim Wechsel nicht störend im Weg stehen. Um seine Endlage einzunehmen, in der das Filterelement eine Lüftungsöffnung des Schaltschranks oder Baugruppenträgers im Wesentlichen abdichten soll, sind erfindungsgemäß Mittel vorgesehen, die das Filterelement bzw. ein das Filterelement tragendes Filtergehäuse um ein Maß senkrecht zur Einschubrichtung bewegen bzw. anheben. Das Filterelement wird erfindungsgemäß also entlang einer zweidimensionalen Bewegungsbahn geführt, obwohl die Betätigung durch eine Schub- oder Zugbeaufschlagung im Wesentlichen eindimensional erfolgt, und zwar in Einschubrichtung des Einfuhrschachts. Das Filterelement lässt sich dadurch vorteilhaft sehr platzsparend einsetzen und gleichzeitig sicher in seine Endlage bringen, die beispielsweise hinter Kabelkanälen liegen kann.

Im Folgenden soll die Erfindung anhand eines Schaltschranks weiter erläutert werden, wobei dies nur eine mögliche Anwendung darstellt und insbesondere nicht einschränkend verstanden werden soll.

In einer einfachsten Ausführungsform des Filtersystems ist ein Filtergehäuse vorgesehen, welches zur Aufnahme eines vorzugsweise mattenförmigen Filterelements ausgebildet ist.
Das Filtergehäuse stabilisiert das Filterelement in seiner Lage und hält es- beispielsweise gegen Ansaugdruck - in Form. Erfindungsgemäß ist das Filtergehäuse im Wesentlichen abdichtend gegen eine Lüftungsöffnung anlegbar, die am Schaltschrank zu diesem Zweck ausgebildet ist. In dieser Endlage dichtet das Filtergehäuse mit dem darin liegenden Filterelement die vorgesehene Lüftungsöffnung so ab, dass in den Schaltschrankbereich eingesogene Luft durch das Filterelement hindurchströmt und dabei gereinigt wird.

Erfindungsgemäß ist das Filtergehäuse über einen Einfuhrschacht einsetzbar. Dabei ist es entlang dieses Schachts mittels eines Schubelements beweglich, wobei diese Bewegung in eine erste, üblicherweise laterale Richtung X erfolgen soll. Ein einzusetzendes Filtergehäuse nimmt dabei während der Schubbewegung in Richtung X eine Einschublage ein, die sich bezüglich der X-Richtung bereits relativ nahe an der angestrebten Endlage befindet, bevor ein Versatz in Y-Richtung erfolgt. Vorteilhafterweise ist der Einfuhrschacht also so ausgebildet, dass das Filtergehäuse durch eine Schub- bzw. Zugbewegung beispielsweise von unterhalb des Schaltschranks nach vorne herausziehbar ist bzw. auf gleichem Weg wieder eingesetzt werden kann. Der Schacht kann dabei unterhalb des Schaltschranks bzw. etwaiger Kabelkanäle angeordnet sein und behindert dabei die eigentliche Schaltschrankfunktion nicht.

Um das Filtergehäuse aus der Einschublage in seine Endlage zu bringen, sind erfindungsgemäß Mittel vorgesehen, die bei fortgesetzter Schubbeaufschlagung über die Einschublage hinaus wenigstens einen Teil des Filtergehäuses in eine zweite, zur ersten Richtung X senkrechte Richtung Y bewegen. Dadurch besteht die Möglichkeit, das Filtergehäuse - etwa nachdem es unterhalb eines Kabelkanals waagerecht durchgeschoben wurde - um ein Maß senkrecht nach oben anzuheben und dabei gegen eine Lüftungsöffnung im Boden des Schaltschranks zu drücken. Die Mittel sind dabei so ausgeführt, dass die Bewegung in Y-Richtung zwangsgeführt erfolgt und ausschließlich aus der Schubbeaufschlagung des Filtergehäuses in X-Richtung resultiert. Diese zweidimensionale Einsetzbewegung des Filtergehäuses bei im Wesentlichen eindimensionaler Schub- bzw. Zugbeaufschlagung erlaubt ein platzsparendes Filtersystem. Auch wird dadurch ermöglicht, im Weg stehende Komponenten mit dem Filtergehäuse im Rahmen des Einsetzens zu "hintergreifen", wodurch Installationsraum vorteilhaft nutzbar ist. Anders als beim Stand der Technik müssen beispielsweise Kabelkanäle, die sich an der Vorderkante bzw. leicht unterhalb des Schaltschranks befinden, für einen Filterwechsel nicht mehr demontiert bzw. bewegt werden, um dahinter ein Filtergehäuse von unten gegen eine Lüftungsöffnung im Schaltschrank zu setzen.

Dies stellt insbesondere für Glasfaserkabel einen erheblichen Vorteil dar, da diese gegen Berührung hochempfindlich sind. Die Gefahr von Signalverzerrungen oder Datenverlust wird durch das erfindungsgemäße Filtersystem daher vorteilhaft vermieden.

Nach einer weiteren vorteilhaften Ausführungsform der Erfindung weist das Filterelement mit seinem Filtergehäuse im Wesentlichen ebene Gestalt auf. Gleichzeitig ist die Endlage in etwa parallel zur Einschublage angeordnet. Das bedeutet, dass das Filtergehäuse im Wesentlichen durch eine Parallelverschiebung aus der Einschublage in die Endlage bewegbar ist. Dies ist mit relativ einfachen mechanischen Mitteln zu bewerkstelligen, beispielsweise sind gleichförmige Rampen zum Anheben des Filtergehäuses aus der Einschublage bis hinauf in die Endlage denkbar.

Weiterhin kann das Filtergehäuse durch eine ausschließlich translatorische Bewegung aus der Einschublage in die Endlage bewegt werden, was durch relativ einfache mechanische Mittel zu bewerkstelligen ist. Insbesondere kann das Filtergehäuse über Stellbügel so an dem Schubelement angelenkt sein, dass ausschließlich eine translatorische Schwenkbewegung des Filtergehäuses relativ zum Stellbügel zugelassen wird. Durch die translatorische Bewegung wird einerseits eine Bewegung in Y-Richtung des Filtergehäuses relativ zur Einschubrichtung X möglich, andererseits kann das Filtergehäuse durch eine Einklappbewegung im Wesentlichen in die Ebene der Schubrichtung X zurückgeklappt werden, um dann entlang dieser Ebene herausgezogen und ausgewechselt zu werden.

Nach einer weiteren vorteilhaften Ausführungsform der Erfindung umfassen die Mittel zur Beaufschlagung in eine Y-Richtung wenigstens ein Führungselement, welches so ausgebildet ist, dass das Filtergehäuse aus der Einschublage im Wesentlichen entlang einer translatorischen Bewegung in die Endlage bewegt wird. Das Führungselement kann dabei als einfache Rampe ausgebildet sein, die sich in Schubrichtung hinter der Einschublage befindet. Sobald das Filtergehäuse über die Einschublage hinaus in den Einfuhrschacht hineingeschoben wird, wirkt es mit seiner Vorderkante mit diesem Führungselement zusammen und wird dadurch um ein Maß in Y-Richtung angehoben. Bei entsprechend translatorischer Anbindung des Filtergehäuses an das Schubelement hebt sich das gesamte Filtergehäuse aus der Einschubebene ab und gelangt im Rahmen einer Parallelverschiebung in seine Endlage an der Lüftungsöffnung des Schaltschranks.

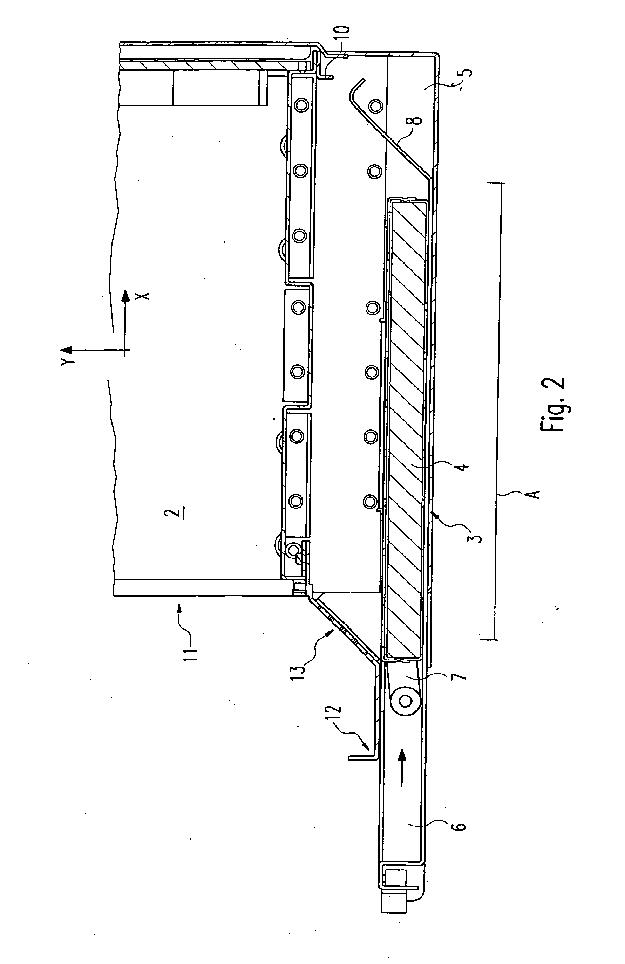

Andererseits ist auch die nicht-translatorische Bewegung des Filtergehäuses aus der Einschublage in die Endlage denkbar. So kann das Filtergehäuse zum Beispiel nur einfach an dem Schubelement angehängt sein, so dass es dazu relativ frei schwenkbar ist. In Verbindung mit einem als Rampe ausgebildeten Führungselement wird auch dann das Filtergehäuse in die Endlage bewegt, wobei dies im Rahmen einer nicht-translatorischen Schwenkbewegung erfolgt (dies wird anhand der Fig. 2 noch beschrieben).

Erfindungsgemäß ist in einer weiteren Ausführungsform vorgesehen, dass die Schubbewegung des Filtergehäuses in X-Richtung durch einen Anschlag begrenzt ist. Dadurch wird sichergestellt, dass das Filtergehäuse die gewünschte X-Position in der Endlage exakt einnimmt und darüber hinaus wirkt dieser Anschlag auf die Schwenkbewegung des Filtergehäuses relativ zum Schubelement ein und stellt so die exakte Annahme des Filtergehäuses auch in Y-Richtung (Anpressdruck) sicher.

Nach einer weiteren vorteilhaften Ausführungsform der Erfindung ist vorgesehen, dass das Filtergehäuse und/oder das Schubelement in seiner Lage verriegelbar ist, nachdem das Filtergehäuse die Endlage eingenommen hat. Die Verriegelung kann als einfacher, manuell lösbarer Rastmechanismus ausgebildet sein, der beispielsweise das Schubelement im eingeschobenen Zustand in dem Einfuhrschacht fixiert. Die Verriegelung stellt sicher, dass das Filtergehäuse seine Endlage nicht selbsttätig verlässt, so dass die Filterfunktion jederzeit gewährleistet ist. Ein manuell lösbarer Rastmechanismus erlaubt darüber hinaus das einfache Wechseln des Filtergehäuses.

Nach einer weiteren vorteilhaften Ausführungsform der Erfindung ist die Öffnungsweite des Einfuhrschachts in Y-Richtung kleiner als der Abstand zwischen der Einschublage und der Endlage in dieser Richtung. Das bedeutet, dass das Filtergehäuse entlang eines in der Bauhöhe relativ flachen Einfuhrschachts beispielsweise unterhalb des Schaltschranks einschiebbar ist, während es sich aus der dann eingenommenen Einschublage um ein Maß in Y-Richtung senkrecht zur Einschubrichtung X bewegt, wobei dieses Maß die Öffnungsweite des Einfuhrschachts übersteigt. Während also zum Einsetzen des Filtergehäuses nur ein relativ flacher Einschubschlitz - beispielsweise unterhalb des Schaltschranks - nötig ist, kann das Filtergehäuse in der Tiefe des Einschubschachts um ein Maß in Y-Richtung abgelenkt werden, die die Einschubhöhe des Einfuhrschachts deutlich übersteigt. So lässt sich das Filtergehäuse leicht und sicher auch in Y-Richtung bewegen bzw. andrücken, wobei diese Bewegung ausschließlich aus der Beaufschlagung über das Schubelement in X-Richtung erfolgt.

Weiterhin geschützt ist ein Schaltschrank oder Baugruppenträger-Gehäuse mit einem Filtersystem nach einer der vorbeschriebenen Ausführungsformen. Besonders vorteilhaft ist der Schaltschrank dann ausgebildet, wenn das Filtersystem in einen Einfuhrschacht unterhalb des Schaltschrankgehäuses einschiebbar ist. Dieser Bodenbereich ist über einen zur Vorderseite des Schachtschranks hingezogenen Einfuhrschacht leicht zugänglich. Auch ist die Anordnung mehrerer solcher Schaltschränke unmittelbar benachbart zueinander problemlos möglich. Eine werkzeuglose Bedienbarkeit des Schubelements erlaubt den schnellen und unkomplizierten Wechsel des oder der Filterelemente, oder auch der kompletten Einheiten von Filtergehäusen und Filterelementen.

Vorteilhafterweise erlaubt das Filtersystem eine frontseitige Wartung, die auch im Betriebszustand des Schaltschranks möglich ist. Die geringe Bauhöhe gestattet ferner eine besonders kompakte, leicht zu handhabende und kostengünstige Bauweise.

Weitere vorteilhafte Ausführungsformen ergeben sich aus den Unteransprüchen.

Nachfolgend wird eine Ausführungsform der Erfindung anhand eines Figurenbeispiels näher erläutert. Von den Figuren zeigen
- Fig. 1: eine schematische perspektivische Ansicht von Teilen des Filtersystems,
- Fig. 2: das Filtersystem mit eingeschobenem Filtergehäuse, und
- Fig. 3: das Filtersystem gemäß Fig. 2 mit Filtergehäuse in der Endlage.

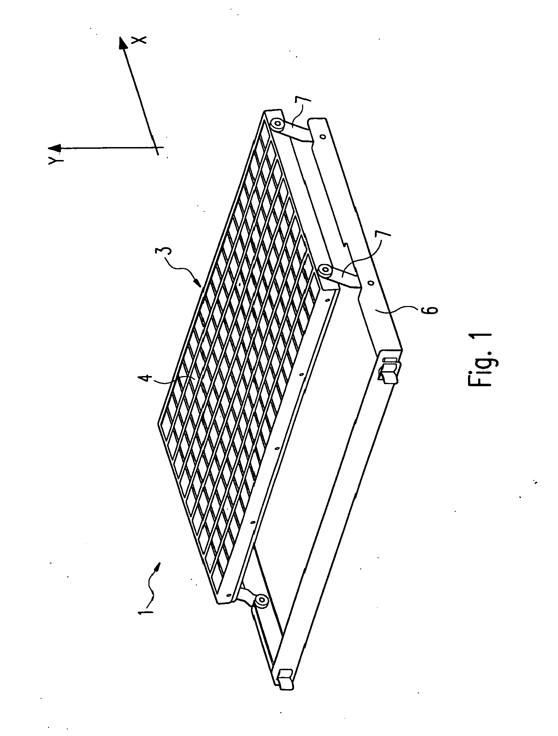

In Fig. 1 ist auszugsweise ein Filtersystem 1 dargestellt. Es umfasst ein Schubelement 6, welches an einer Vorderseite über einen Querbügel besonders leicht bedienbar ist. An das Schubelement 6 ist über vier Stellbügel 7 ein Filtergehäuse 3 angelenkt, welches zur Aufnahme eines Filterelements 4 ausgebildet ist.

Das Filtergehäuse 3 ist im Rahmen einer translatorischen Bewegung relativ zum Schubelement 6 schwenkbar und kann insbesondere in die Ebene zurückgeklappt werden, die im Wesentlichen durch die Rechteckform des Schubelements 6 definiert wird. In diese eingeklappte Lage lässt sich das Schubelement 6 mitsamt dem Filtergehäuse 3 in X-Richtung in einen Einführschacht einschieben. Außerhalb des Einführschachts lässt sich das Filterelement 4 des Filtergehäuses 3 leicht wechseln.

Fig. 2 zeigt in schematischer Seitenansicht das Unterteil eines elektrischen Schaltschranks 2. Unterhalb des Schaltschranks 2 ist ein sich im Wesentlichen von links nach rechts streckender Einführschacht 5 ausgebildet, der von unterhalb der Vorderseite 11 des Schaltschranks zugänglich ist. In den Einführschacht 5 ist das Schubelement 6 mit dem daran angelenkten Filtergehäuse 3 eingesetzt und um ein Maß in Richtung auf die Schaltschrankrückwand bzw. in Richtung X eingeschoben.

Das Filtergehäuse 3 mit dem darin liegenden Filterelement 4 ist gemäß Darstellung in Fig. 2 kurz vor Einnahme in eine Einschublage A gezeigt. Bei fortgesetzter Schubbeaufschlagung des Schubelements 6 in Pfeilrichtung bzw. Richtung X wird das Filtergehäuse 3 die Einschublage A einnehmen.

Die Einschublage A ist in Einschubrichtung X begrenzt durch ein Führungselement 8, welches sich um ein Maß in Richtung Y erstreckt. Bei fortgesetzter Schubbeaufschlagung des Filtergehäuses 3 führt das Führungselement 8 die Vorderkante des Filtergehäuses 3 um ein Maß nach oben in Richtung auf eine in Fig. 2 nicht dargestellte Endlage B. Sofern das Filtergehäuse 3 relativ zum Schubelement 6 translatorisch beweglich angelenkt ist, hebt sich das gesamte Filtergehäuse 3 bei Beaufschlagung durch das Führungselement 8 im Wesentlichen parallel zur Einschubrichtung X nach oben und gelangt schließlich an die Unterseite des Schaltschranks 2 bzw. dessen dortige Lüftungsöffnung. Ist das Filtergehäuse 3 dagegen nicht zur translatorischen Bewegung an dem Schubelement 6 angelenkt, sondern beispielsweise nur durch eine einfache gelenkige Anbindung mit einem Stellbügel 7, so bewegt das Führungselement 8 zunächst nur die hintere Kante des Filtergehäuses 3 nach oben in Richtung Y. Das Filtergehäuse 3 steht dabei zunächst um ein Maß schräg zur Einführrichtung X, bis es mit seiner Hinterkante schließlich an den Anschlag 10 gelangt. Bei fortdauernder Schubbeaufschlagung hebt sich über die vorderen Stellbügel 7 schließlich auch die zur Vorderwand 11 des Schaltschranks weisende Kante des Filtergehäuses 3 aus der Einschubebene ab und wird ebenfalls in Y-Richtung nach oben gegen die Lüftungsöffnung des Schaltschranks 2 bzw. in die gewünschte Endlage gedrückt. Der Kabelkanal 12 bleibt dabei vorteilhafterweise unbewegt, so dass darin laufende Kabel sicher geschützt sind. Frischluft kann insbesondere über den Lufteintritt 13 angesaugt werden.

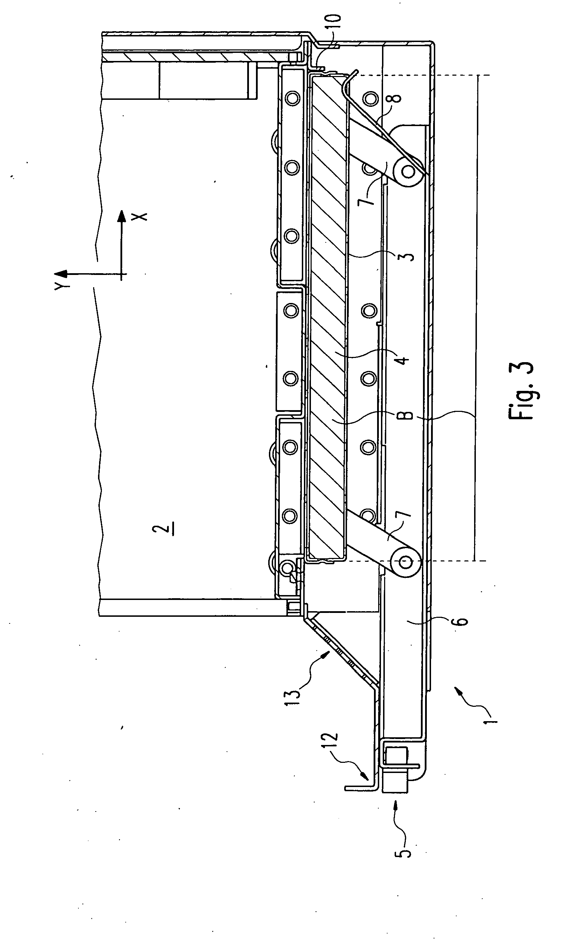

In Fig. 3 ist das Filtergehäuse 3 mit dem Filterelement in der angestrebten Endlage B dargestellt. Die Endlage B ist um ein Maß in Y-Richtung relativ zur Einschubebene nach oben versetzt. Zu erkennen ist weiterhin, dass das (in diesem Fall translatorisch am Schubelement 6 angelenkte) Filtergehäuse 3 durch das Führungselement 8 bzw. den Anschlag 10 in X- und Y-Richtung fixiert ist. Das Schubelement 6 ist innerhalb des Einführschachts 5 über einen nicht näher dargestellten Verriegelungsmechanismus so gesichert, dass das Filtergehäuse 3 seine Endlage B nicht selbsttätig verlassen kann.

Sofern das Schubelement 6 in entgegengesetzte X-Richtung aus dem Einführschacht 5 herausgezogen wird, senkt sich das Filtergehäuse 3 in analoger Bewegungsumkehr zunächst aus der Endlage B wieder herab, wobei es die Einschublage A (Fig. 2) einnimmt. Bei weiterer Zugbewegung lässt sich das Filtergehäuse 3, welches nun im Wesentlichen vollständig die Ebene der Einschubrichtung X bzw. des Einführschachts 5 einnimmt, vollständig nach links herausziehen, so dass das Filterelement 4 gewechselt werden kann.

## Patentansprüche

1. Filtersystem (1), insbesondere zur Luftreinigung eines zu belüftenden Schaltschranks oder Baugruppenträgers (2),
a) mit einem Filtergehäuse (3) zur Aufnahme wenigstens eines vorzugsweise mattenförmigen Filterelements (4),
b) wobei das Filtergehäuse (3) im wesentlichen abdichtend gegen eine Lüftungsöffnung, insbesondere des Schaltschranks oder Baugruppenträgers (2), anlegbar ist und dabei eine Endlage (B) einnimmt,
**dadurch gekennzeichnet, dass**
c) das Filtergehäuse (3) zum Einsetzen in einen Einfuhrschacht (5) ausgebildet ist, entlang dessen es mittels eines Schubelements (6) durch eine Schubbeaufschlagung in einer ersten Richtung (X) in eine Einschublage (A) bewegbar ist, und wobei
d) das Filtersystem (1) Mittel (8) vorsieht, durch die wenigstens ein Teil des Filtergehäuses (3) nach Einnahme der Einschublage (A) bei fortgesetzter Schubbeaufschlagung eine Beaufschlagung in eine zweite, zur ersten Richtung (X) senkrechte Richtung (Y) erfährt, um **dadurch** in die Endlage (B) geführt zu werden.

2. Filtersystem nach Anspruch 1, **dadurch gekennzeichnet, dass** das Filterelement (4) im Wesentlichen ebene Gestalt hat und die Endlage (B) parallel zur Einschublage (A) angeordnet ist.

3. Filtersystem nach einem der vorhergehenden Ansprüche, **dadurch gekennzeichnet, dass** das Filtergehäuse (3) über Stellbügel (7) relativ zum Schubelement (6) translatorisch verschwenkbar ist.

4. Filtersystem nach einem der vorhergehenden Ansprüche, **dadurch gekennzeichnet, dass** die Mittel (8) wenigstens ein Führungselement umfassen, welches so ausgebildet ist, dass das Filtergehäuse (3) aus der Einschublage (A) im wesentlichen entlang einer translatorischen Bewegung in die Endlage (B) bewegt wird.

5. Filtersystem (1) nach einem der vorhergehenden Ansprüche, **dadurch gekennzeichnet, dass** die Mittel (8) wenigstens ein als Rampe ausgebildetes Führungselement umfassen.

6. Filtersystem (1) nach einem der vorhergehenden Ansprüche, **dadurch gekennzeichnet, dass** die Schubbewegung des Filtergehäuses (3) in X-Richtung durch einen Anschlag (10) begrenzt ist.

7. Filtersystem nach einem der vorhergehenden Ansprüche, **dadurch gekennzeichnet, dass** das Filtergehäuse (3) und/oder das Schubelement (6), nach dem das Filtergehäuse (3) die Endlage (B) eingenommen hat, in seiner Lage verriegelbar ist.

8. Filtersystem nach einem der vorhergehenden Ansprüche, **dadurch gekennzeichnet, dass** die Öffnungsweite des Einfuhrschachts (5) in Y-Richtung kleiner ist als der Abstand zwischen Einschublage (A) und Endlage (B) in Y-Richtung.

9. Schaltschrank oder Baugruppenträger (2) mit einem Filtersystem (1) nach einem der vorhergehenden Ansprüche.

10. Schaltschrank oder Baugruppenträger (2) nach dem vorhergehenden Anspruch, **dadurch gekennzeichnet, dass** das Filtersystem (1) in einen Einfuhrschacht (5) unterhalb des Schaltschrankgehäuses oder Baugruppenträgers (2) einschiebbar ist.

11. Schaltschrank oder Baugruppenträger (2) nach einem der beiden vorhergehenden Ansprüche, **dadurch gekennzeichnet, dass** das Schubelement (6) werkzeuglos bedienbar ist.
